Europäisches Patentamt

European Patent Office

Office européen des brevets

(19)

(11) Numéro de publication: **0 161 160**
**A1**

(12) ## DEMANDE DE BREVET EUROPEEN

(21) Numéro de dépôt: 85400687.1

(22) Date de dépôt: 05.04.85

(51) Int. Cl.⁴: **G 11 C 19/08**

(30) Priorité: 12.04.84 FR 8405812

(43) Date de publication de la demande:
13.11.85 Bulletin 85/46

(84) Etats contractants désignés:
DE GB NL

(71) Demandeur: COMMISSARIAT A L'ENERGIE ATOMIQUE Etablissement de Caractère Scientifique Technique et Industriel
31/33, rue de la Fédération
F-75015 Paris(FR)

(72) Inventeur: Fedeli, Jean-Marc
3, rue Bach Le Fontanil-Cornillon
F-38120 Saint Egreve(FR)

(72) Inventeur: Magnin, Joel
3, rue Doyen Gosse
F-38400 Saint Martin D'heres(FR)

(74) Mandataire: Mongrédien, André et al,
c/o BREVATOME 25, rue de Ponthieu
F-75008 Paris(FR)

(54) **Porte d'échange dans une mémoire à bulles magnétiques à motifs non implantés et mémoire à bulles de type série-parallèle comportant au moins une desdites portes d'échange.**

(57) Porte d'échange dans une mémoire à bulles magnétiques à motifs non implantés et mémoire à bulles de type série-parallèle comportant au moins une desdites portes d'échange.

Dans une mémoire à bulles magnétiques comportant un premier ensemble (2) de motifs non implantés alignés et un second ensemble (4) de motifs non implantés alignés, la porte d'échange de l'invention comprend un conducteur de transfert (28) pour transférer une bulle magnétique du second ensemble de motifs vers le premier ensemble de motifs et se caractérise en ce qu'elle comprend en outre un conducteur d'effacement (30a) pour effacer la bulle à remplacer sur le premier ensemble de motifs.

FIG. 3

EP 0 161 160 A1

## Porte d'échange dans une mémoire à bulles magnétiques à motifs non implantés et mémoire à bulles de type série-parallèle comportant au moins une desdites portes d'échange

La présente invention a pour objet une porte d'échange dans une mémoire à bulles magnétiques à motifs non implantés. Elle a également pour objet une mémoire à bulles magnétiques de type série-parallèle comportant au moins une desdites portes d'échange.

L'invention s'applique notamment à la mémorisation d'informations binaires ou bits, matérialisés sous la forme de domaines magnétiques isolés, qualifiés de bulles ; ces domaines généralement cylindriques, présentent une aimantation inverse de celle du reste du matériau magnétique (grenat) constituant la couche dans laquelle ces domaines sont formés. Dans cette mémoire, la duplication de bulles magnétiques permet notamment d'effectuer la duplication d'élément binaire par élément binaire ou la duplication par bloc d'éléments binaires.

Dans une couche magnétique monocristallin telle qu'un film de grenat magnétique, supporté par un grenat monocristallin amagnétique, les domaines ou bulles magnétiques sont stables par application d'un champ magnétique continu Hp perpendiculaire au plan de la couche magnétique. Dans la pratique, ce champ magnétique est créé par un aimant permanent assurant ainsi la non volatilité des informations contenues dans la mémoire.

Dans une mémoire à bulles magnétiques, le déplacement des bulles est réalisé en appliquant un champ continu tournant $H_T$ suivant une direction parallèle à la surface de la couche magnétique. Le déplacement des bulles se fait autour de motifs dits de propagation, définis dans la partie supérieure de la couche magnétique.

Ces motifs présentant la forme de disques, de losanges, de triangles, de T etc... peuvent être réalisés en un matériau à base de fer et de nickel, ou bien obtenus en implantant des ions dans la partie supérieure de la couche magnétique, à travers un masque permettant de définir la forme de ces motifs. Dans ce dernier cas, étant donné que l'implantation ionique n'est effectuée qu'autour des motifs, ces motifs sont appelés des motifs non implantés. Les motifs de propagation sont généralement contingus ; du fait de leur forme, deux motifs adjacents délimitent entre eux deux cavités ou creux.

Le déplacement des bulles le long de ces motifs se fait généralement pendant une durée égale au tiers de la période de rotation du champ magnétique $H_T$ plan, les bulles restant immobiles dans les cavités définies entre deux motifs adjacents, pendant le reste du cycle. Ces cavités constituent des positions dites stables. On réalise ainsi des registres à décalage dans lesquels l'information binaire "1" est représentée par la présence d'une bulle et l'information binaire "0" par l'absence d'une bulle.

En plus de ces motifs de propagation, il est nécessaire d'utiliser des conducteurs électriques pour réaliser dans la mémoire à bulles, des fonctions d'écriture, d'enregistrement de l'information, de lecture non destructive, de transfert de registre à registre et d'effacement.

Un des principaux types de mémoire à bulles magnétiques connu comprend un ensemble de boucles, ou registres, dites mineures servant au stockage des informations, associé à une ou deux boucles, ou registres, dites majeures, constituant les stations d'accès

B 8247.3 BL

à la mémoire. Les boucles mineures sont disposées longitudinalement, les unes à côté des autres et les boucles majeures sont orientées perpendiculairement aux boucles mineures. Les bulles magnétiques se trouvant dans les boucles mineures peuvent être transférées dans les boucles majeures et réciproquement, par l'intermédiaire de portes de transfert unidirectionnelles ou bidirectionnelles.

Lorsque l'on utilise une seule boucle majeure, la lecture et l'écriture des informations se font au moyen de cette unique boucle. Dans ce premier cas, on parle d'une mémoire présentant une organisation majeure mineure. En revanche, lorsque l'on utilise deux boucles majeures, l'écriture des informations se fait par l'intermédiaire de l'une de ces deux boucles et la lecture des informations par l'intermédiaire de l'autre boucle. Ces boucles majeures sont généralement situées de part et d'autre des boucles mineures. Dans ce dernier cas (deux boucles), on parle généralement d'une mémoire présentant une organisation série-parallèle.

Dans les mémoires à bulles décrites ci-dessus, la fabrication d'une bulle sur une boucle majeure, correspondant à l'écriture d'une information, est réalisée en appliquant un courant élevé à un conducteur, généralement en forme de U, traversant les motifs de propagation constituant la boucle majeure. Cette opération généralement connue sous le nom de nucléation est réalisée lorsque la bulle est dans une cavité définie entre deux motifs adjacents.

Après nucléation, la bulle est ensuite propagée, par application du champ tournant $H_T$, sur la boucle majeure vers les portes de transfert afin de transférer la bulle de la boucle majeure vers une boucle mineure. Ces portes de transfert sont généralement

B 8247.3 BL

réalisées par un conducteur en forme de U traversant les motifs constituant la boucle mineure. L'application d'une impulsion de courant à ce conducteur permet d'étendre chaque bulle entre les sommets des motifs de propagation de la boucle majeure et ceux correspondants de la boucle mineure et ensuite, l'arrêt de l'impulsion de courant entraîne la contraction des bulles sur la boucle mineure. Le transfert est alors réalisé. L'information est ainsi stockée sur la boucle mineure.

La lecture de cette information se fait en transférant une bulle magnétique d'une boucle mineure vers une boucle majeure. Le transfert se fait comme précédemment.

Pour effectuer la lecture d'une information de manière non destructive la bulle correspondante doit être dupliquée. Dans le cas d'une duplication bulle par bulle, cette duplication est réalisée au moyen d'un conducteur traversant la boucle majeure auquel on applique une impulsion de courant, entraînant l'élongation de la bulle de part et d'autre des chemins de propagation puis la coupure de cette bulle en deux. L'une de ces bulles, transférée sur un chemin de détection, pourra être détectée de façon destructive par un détecteur magnétorésistif, généralement à base de fer et de nickel, et l'autre bulle sera réinjectée dans la boucle mineure à la place occupée par la bulle d'origine.

Une porte d'échange, telle que celle de l'invention, permet de remplacer une information par une autre dans une boucle d'une mémoire à bulles. Ces portes d'échange sont principalement utilisées pour écrire une information dans une boucle mineure par transfert de cette information de la boucle majeure d'écriture vers cette boucle mineure. Cependant, cette porte d'échange peut bien entendu être utilisée dans n'importe quelle partie d'une mémoire à bulles à chaque fois qu'une information doit être remplacée par une autre.

Une porte d'échange pour une mémoire à bulles à motifs non implantés est décrite dans le brevet américain n° 4 394 746 déposé le 16 décembre 1981 et intitulé "Swap Gate for Ion-implanted Contiguous-disk Bubble Devices". On a représenté sur la figure 1 une porte d'échange selon l'enseignement de ce brevet. La figure 2 illustre le fonctionnement de cette porte d'échange.

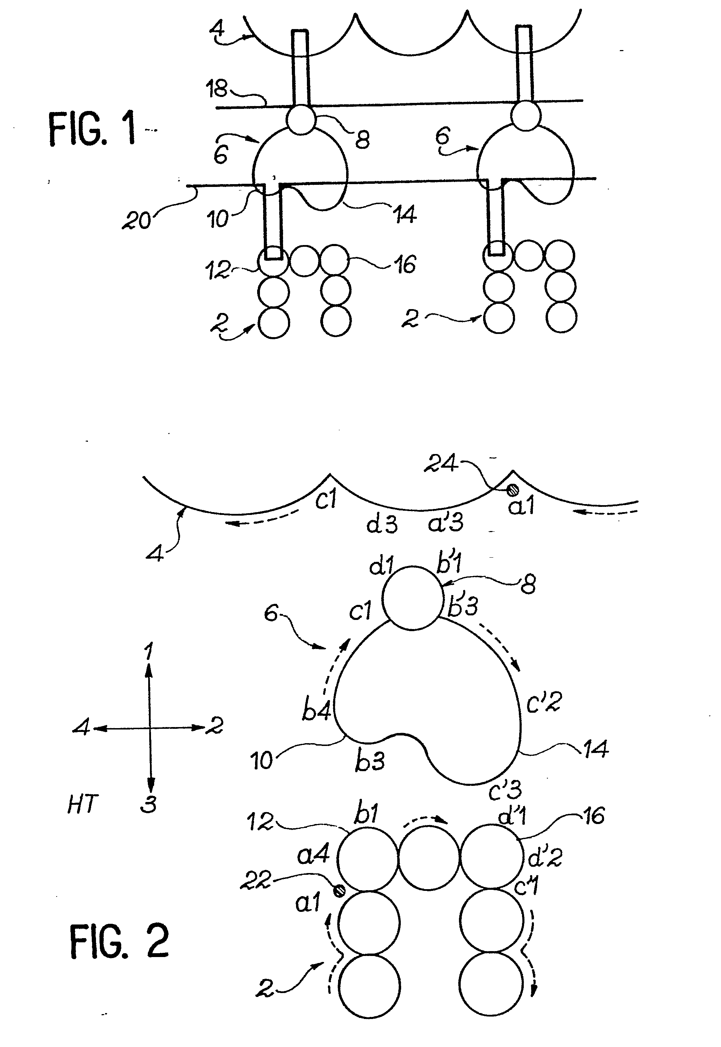

Sur la figure 1, on a représenté des boucles mineures repliées 2, une boucle majeure 4 et des éléments d'échange 6 disposés entre la boucle majeure et la partie terminale repliée des boucles mineures.

Chaque élément d'échange 6 a une première partie 8 pour échanger des bulles avec la boucle majeure, une deuxième partie 10 pour recevoir des bulles d'une première région 12 de la partie repliée de la boucle mineure 2, et une troisième partie 14 pour transférer les bulles de la première partie 8 à une seconde région 16 de la partie repliée de la boucle mineure 2. Un motif 18 est disposé entre la première région 12 et la seconde région 16 de la boucle mineure 2 pour former deux positions de stockage des bulles dans la boucle mineure 2.

Un premier conducteur 18 est en outre disposé entre la boucle majeure et la première partie 8 de l'élément d'échange pour former une première porte de transfert. Un second conducteur 20 est également disposé entre la deuxième partie 10 de l'élément d'échange et la première région 12 de la boucle mineure pour former une deuxième porte de transfert. Enfin, la troisième partie 14 de l'élément d'échange est dispo-

B 8247.3 BL

sée de manière à former avec la seconde région 16 de la boucle mineure un élément de réunion.

On a représenté sur la figure 2 une vue agrandie d'un élément d'échange disposé entre une boucle mineure et la boucle majeure. Sur cette figure, des flèches en pointillé rappellent le sens du mouvement des bulles magnétiques le long des motifs non-implantés. Sur cette figure, on a indiqué les positions successives d'une bulle magnétique 22 à transférer sur la boucle majeure et d'une bulle magnétique 24 à transférer sur la boucle mineure en fonction des phases du champ tournant $H_T$ numérotées 1, 2, 3, 4. Les lettres a, b, c et d notent des tours successifs du champ tournant $H_T$. Les lettres a', b', c' et d' ont la même signification. Pour la clarté de la figure, les conducteurs électriques n'ont pas été représentés.

Le remplacement dans la boucle mineure de la bulle magnétique 22 par la bulle magnétique 24 se fait de la manière suivante. Pendant le premier tour du champ $H_T$, la bulle magnétique 24 est déplacée le long de la boucle majeure 4 et est transférée vers la première partie 8 de l'élément d'échange 6 par une impulsion de courant adéquate sur le conducteur de transfert. Pendant ce temps, la bulle 22 se déplace sur la boucle mineure 2 et atteint la première région 12.

Pendant la première moitié du second tour b du champ tournant $H_T$, cette bulle est transférée vers la deuxième région 10 de l'élément d'échange 6. Elle se propage ensuite le long de ce motif dans le sens des aiguilles d'une montre jusqu'à atteindre la première partie 8 de l'élément d'échange au début du quatrième tour (d) du champ tournant $H_T$.

De même, pendant le deuxième tour (b') et la première moitié du troisième tour (c') du champ tournant $H_T$, la bulle 24 se déplace le long de l'élément d'échange 6 pour atteindre la troisième partie 14. Dans la deuxième moitié de ce troisième tour (c'), cette bulle est transférée vers la seconde partie 16 de la boucle mineure 2. La bulle magnétique 24 occupe ainsi à l'instant d'1 la position qu'aurait occupée la bulle 22 si elle s'était propagée le long de la boucle mineure 2. Le remplacement de la bulle 22 par la bulle 24 est ainsi réalisé. Il reste toutefois à transférer la bulle 22 en position d1 sur la boucle majeure par une impulsion de courant sur le conducteur de transfert, puis à diriger ensuite cette bulle vers un annihilateur situé à l'extrémité de la boucle majeure 4.

La porte d'échange qui vient d'être décrite illustre un art antérieur récent. Dans cette porte d'échange comme dans les autres portes d'échange connues, réalisées aussi bien en motifs non-implantés qu'en alliage magnétique de type fer-nickel, l'écriture d'une information dans une boucle mineure se fait toujours par un double transfert entre la boucle mineure et la boucle majeure, l'information à effacer étant transférée sur la boucle majeure pour être détruite dans un annihilateur.

La porte d'échange de l'invention repose sur un principe différent. Dans celle-ci, le transfert se fait uniquement de la boucle majeure vers la boucle mineure pour apporter la nouvelle information à mémoriser. Dans la porte d'échange de l'invention, l'information à effacer n'est pas transférée vers la boucle majeure mais est détruite directement sur la boucle mineure.

Ceci permet notamment de supprimer l'élément d'échange, donc de simplifier la réalisation des portes d'échange, et permet également de réaliser ce transfert plus rapidement, c'est-à-dire en un nombre plus faible de cycles du champ tournant $H_T$.

B 8247.3 BL

De manière précise, l'invention a pour objet une porte d'échange pour mémoire à bulles magnétiques à motifs non-implantés comportant une couche de matériau magnétique dans laquelle des bulles peuvent être déplacées par application d'un champ tournant $H_T$ selon un premier et un second chemins de propagation, ledit premier chemin étant défini par un premier ensemble de motifs non-implantés alignés suivant un axe, ledit second chemin étant défini par un second ensemble de motifs non-implantés alignés suivant un autre axe, lesdits axes étant transversaux, ladite porte d'échange comprenant un conducteur électrique activé pour transférer une bulle du second chemin de propagation vers le premier chemin de propagation, ladite porte d'échange comprenant en outre, selon l'invention, un conducteur électrique d'effacement coupant le premier ensemble de motifs suivant un axe perpendiculaire à l'axe d'alignement des motifs dudit premier ensemble.

Selon une autre caractéristique de la porte d'échange selon l'invention, l'axe du conducteur électrique est disposé de sorte que la position d'effacement d'une bulle est située sur le sommet d'un motif non-implanté.

De manière préférée, ce motif est l'avant-dernier motif du premier ensemble de motifs non-implantés.

Selon un premier mode de réalisation, le conducteur d'effacement a une forme en U. Selon un second mode de réalisation, le conducteur d'effacement est linéaire et présente, au niveau de la position d'effacement du premier ensemble, une encoche sensiblement parallèle à l'axe d'alignement des motifs dudit premier ensemble.

Les caractéristiques et avantages de l'invention ressortiront mieux de la description qui va suivre, donnée à titre illustratif mais non limitatif, en référence aux dessins annexés, sur lesquels :

- les figures 1 et 2 déjà décrites, illustrent une porte d'échange dans une mémoire à bulles à motifs non-implantés et le fonctionnement de cette porte d'échange selon l'art antérieur,

- la figure 3 illustre un premier mode de réalisation de la porte d'échange dans une mémoire à bulles magnétiques à motifs non-implantés selon l'invention,

- la figure 4 illustre un second mode de réalisation de la porte d'échange dans une mémoire à bulles magnétiques à motifs non-implantés selon l'invention,

- la figure 5a illustre le fonctionnement de la porte d'échange de l'invention,

- la figure 5b est un chronogramme des impulsions de courant appliquées aux conducteurs de transfert et d'effacement de la porte d'échange de l'invention,

- la figure 6 est un dessin schématique de la structure d'une mémoire à bulles magnétiques à motifs non-implantés de type série-parallèle dont les portes d'échange sont conformes à l'invention.

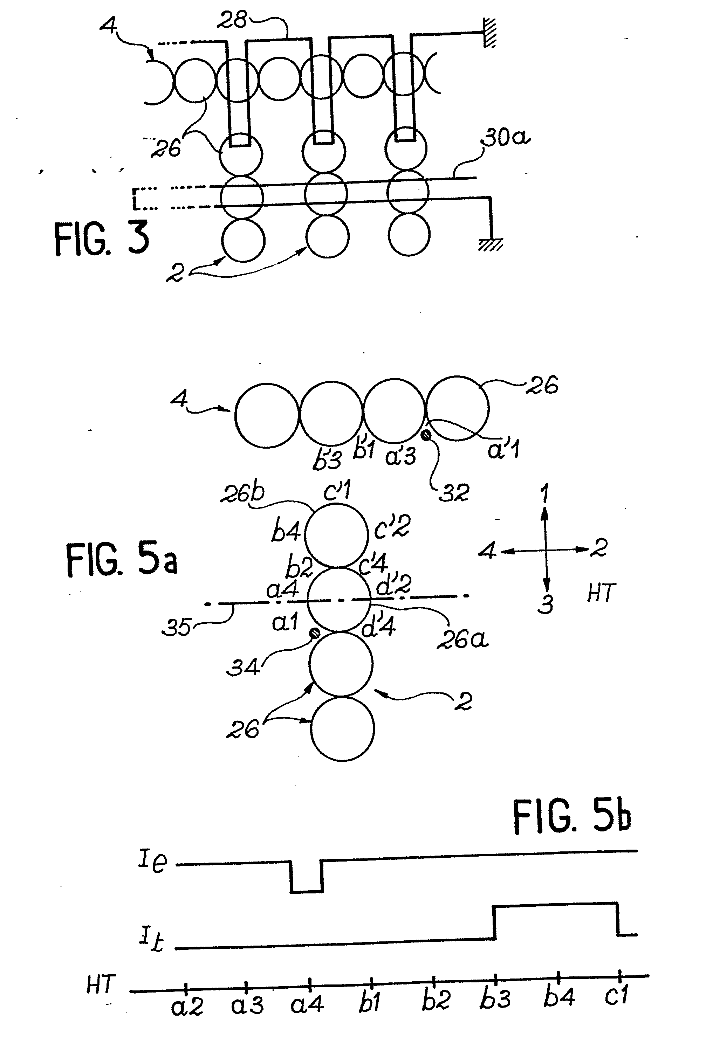

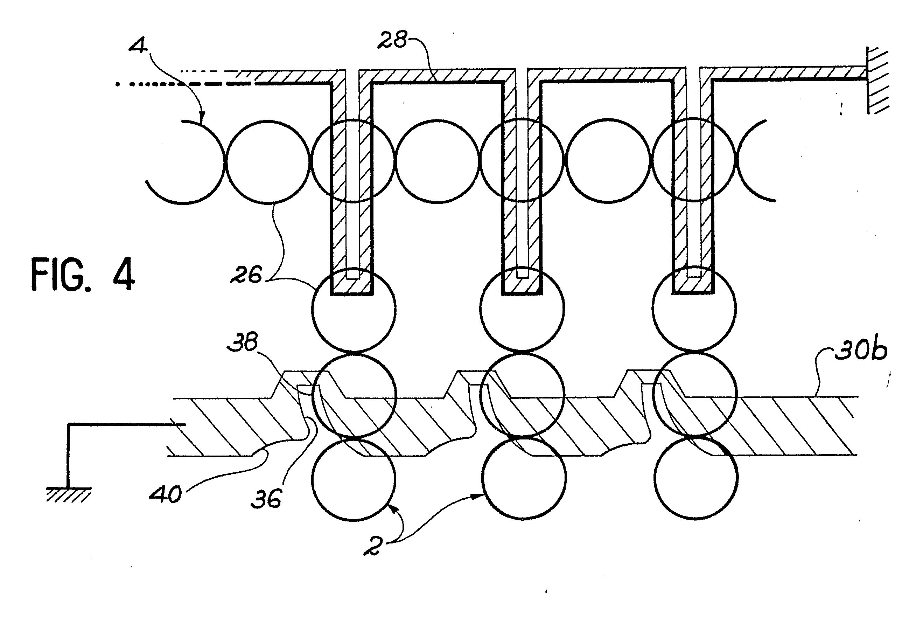

On a représenté sur la figure 3 un premier mode de réalisation de la porte d'échange selon l'invention comprenant deux conducteurs : un conducteur de transfert 28 et un conducteur d'effacement 30a.

Une porte d'échange est disposée entre chaque boucle mineure 2 constituée d'un ensemble de motifs non-implantés 26 alignés et une boucle majeure 4 constituée également d'un ensemble de motifs non implantés 26 alignés suivant un axe perpendiculaire aux boucles mineures.

Le conducteur de transfert 28 permet de

B 8247.3 BL

transférer une bulle de la boucle majeure 4 vers une boucle mineure 2. Il est généralement en forme de U et disposé dans l'axe de la boucle mineure 2 de façon à recouvrir l'extrémité de cette boucle mineure et à traverser la boucle majeure 4.

Selon l'invention, on dispose sur chaque boucle mineure 2 un conducteur d'effacement 30a. Ce conducteur peut par exemple avoir la forme d'un U dont l'axe est parallèle à l'axe de la boucle majeure 4. Il forme ainsi au niveau de chaque boucle mineure 2 un ensemble de deux lignes conductrices parallèles. Lorsqu'une impulsion de courant, de polarité et d'intensité adéquates est appliquée à ce conducteur d'effacement, les bulles de la boucle mineure 2 se trouvant entre les deux lignes parallèles de ce conducteur sont détruites.

On a représenté sur la figure 4 un second mode de réalisation de la porte d'échange de l'invention dans lequel le conducteur d'effacement 30b est linéaire. Sur cette figure, les éléments identiques à ceux de la figure 3 portent les mêmes références.

Le conducteur d'effacement 30b comporte au niveau de chaque position d'effacement une encoche 36 dont la direction est sensiblement perpendiculaire à l'axe du conducteur d'effacement 30b. Cette encoche est centrée de préférence sur la frontière du motif non-implanté et a une profondeur suffisante pour recouvrir la position d'effacement qui, de manière préférée, coïncide avec le sommet 38 du motif non-implanté c'est-à-dire la position de moins grande stabilité d'une bulle magnétique.

La forme générale du conducteur d'effacement 30b est linéaire. Des évidements locaux tels que 40 peuvent cependant être ménagés pour éviter de perturber la progression des bulles sur le chemin de propagation. La forme du conducteur d'effacement est également calculée de manière à éviter des interactions avec les bulles situées de l'autre côté du chemin de propagation.

Le conducteur d'effacement présente l'avantage d'avoir une faible résistance, inférieure à celle du conducteur d'effacement de la porte d'échange de la figure 3, et ne nécessite ainsi qu'un générateur de courant de faible puissance.

On va maintenant décrire le fonctionnement de la porte d'échange de l'invention en référence à la figure 5a. Cette description s'applique aux deux modes de réalisation de l'invention représentés sur les figures 3 et 4.

Sur la figure 5a, on a représenté une boucle mineure 2 et une boucle majeure 4 constituées chacune de motifs non-implantés 26 alignés. Les axes d'alignement de ces deux boucles sont perpendiculaires entre eux et ces boucles sont disposées de manière à ce qu'un transfert d'une bulle magnétique d'une boucle vers l'autre soit possible. Le conducteur de transfert n'a pas été représenté sur cette figure.

On va décrire le fonctionnement de la porte d'échange qui permet à une bulle magnétique 32 présente sur la boucle majeure 4 de remplacer la bulle magnétique 34 présente sur la boucle mineure 2. Pour cela, on a indiqué la position de chacune de ces bulles en fonction de la phase du champ tournant $H_T$ repéré par un chiffre de 1 à 4 et en fonction des tours successifs de ce champ tournant, repérés par des lettres alphabétiques a et b pour la bulle magnétique 34 et a', b', c' et d' pour la bulle magnétique 32.

Pendant le premier tour du champ $H_T$, la bulle magnétique 32 à mémoriser se déplace d'une cavité le long de la boucle majeure 4. Pendant ce temps,

0161160

la bulle magnétique 34 à effacer se propage le long de la boucle mineure 2 et se trouve alignée à l'instant a4 avec le conducteur d'effacement symbolisé par l'axe 35.

L'allure de l'impulsion de courant d'effacement $I_e$ appliquée au conducteur d'effacement est représentée sur la figure 5b en relation avec la phase du champ tournant $H_T$. Le signe de cette impulsion de courant est tel que le champ magnétique qu'elle crée entre les lignes conductrices du conducteur d'effacement a une direction inverse de la direction du champ magnétique de la bulle.

L'impulsion est négative, comme représenté sur la figure 5b, lorsque le conducteur d'effacement 30a, 30b est relié à la masse comme représenté sur les figures 3 et 4 et lorsque le champ magnétique continu Hp est tel que la face visible des bulles magnétiques de la figure 5a est un pôle nord.

Revenant sur la figure 5a, on note que la position d'2 est aussi une position d'effacement. Cependant, l'impulsion d'effacement $I_e$ est appliquée à l'instant 4 du champ tournant $H_T$ et aucune bulle n'est donc présente à l'emplacement d'2 à cet instant. L'impulsion d'effacement permet donc d'effacer uniquement la bulle se trouvant dans la position a4.

Pendant le deuxième tour, noté b', du champ magnétique tournant $H_T$, la bulle magnétique 32 à mémoriser se déplace le long de la boucle majeure 4 jusqu'à la position de transfert. Une impulsion de courant de transfert $I_t$, dont la synchronisation avec le champ tournant $H_T$ est donnée sur la figure 5b, est alors appliquée. Ceci réalise le transfert de la bulle magnétique 32 de la boucle majeure 4 vers la boucle mineure 2.

Au début du troisième tour, noté c', du champ magnétique tournant $H_T$, cette bulle se trouve au sommet de la boucle mineure 2. C'est exactement la position qu'aurait occupée la bulle magnétique 34 si elle n'avait pas été effacée. Le remplacement de l'information est donc réalisé.

Sur la figure 5b, l'impulsion de transfert $I_t$ est positive. Bien entendu, comme pour l'impulsion d'effacement $I_e$, le signe de l'impulsion de transfert est lié à l'extrémité du conducteur de transfert 28 relié à la masse et au sens du champ magnétique continu Hp. L'impulsion de transfert $I_t$ est positive comme représenté sur la figure 5b lorsque le conducteur d'effacement est relié à la masse comme représenté sur les figures 3 et 4 et lorsque le champ magnétique continu Hp a le sens indiqué plus haut.

Le conducteur d'effacement, symbolisé par l'axe 35 sur la figure 5a, traverse l'avant-dernier motif 26a de la boucle mineure 2. Il est clair que cette position n'est pas impérative et que le conducteur d'effacement peut aussi bien être disposé au-dessus de n'importe quel motif de la boucle mineure 2, y compris le dernier motif 26b. Dans ce dernier cas, l'impulsion d'effacement $I_e$ serait reportée de l'instant a4 à l'instant b4.

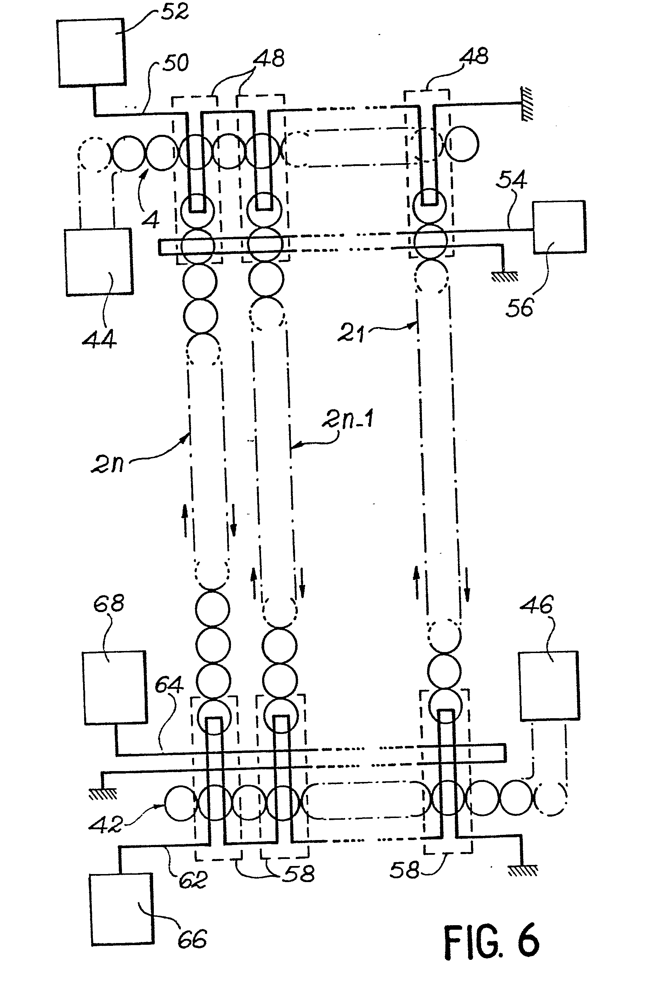

On a représenté sur la figure 6 un dessin schématique d'une mémoire à bulles magnétiques à motifs non-implantés dont les portes d'échange sont conformes à l'invention.

Cette mémoire à bulles comprend principalement n boucles mineures $2_1$, $2_2$,..., $2_n$ alignées longitudinalement, une boucle majeure d'écriture 4 et une boucle majeure de lecture 42 disposées perpendiculairement aux boucles mineures. Les boucles mineures peuvent être alignées par exemple selon un axe de facile aimantation de la couche cristalline de matériau magnétique dans laquelle les bulles magnétiques se déplacent. Un moyen de génération 44 des bulles magnétiques injecte des bulles dans la boucle d'écriture 4. Symétriquement, un détecteur 46, par exemple un détecteur magnéto-résistif, relié à la boucle majeure de lecture reçoit des bulles magnétiques de cette boucle.

Des portes d'échange 48 sont disposées entre chaque boucle mineure et la boucle majeure d'écriture. Selon l'invention, chacune de ces portes d'échange comprend des moyens pour transférer une bulle magnétique de la boucle majeure d'écriture vers une boucle mineure et des moyens pour effacer une bulle magnétique de la boucle mineure.

Dans le mode de réalisation représenté sur la figure 6, le transfert est réalisé par un conducteur 50 relié à un générateur d'impulsions 52 et l'effacement est réalisé par un conducteur d'effacement 54 relié à un générateur d'impulsion 56.

Le conducteur 50 est par exemple constitué d'une suite de segments en forme de U au niveau de chaque boucle mineure. Ces segments, reliés en série, permettent le transfert par bloc de bulles de la boucle majeure 4 vers les boucles mineures. Le conducteur d'effacement 54 est par exemple en forme de U disposé perpendiculairement aux boucles mineures et les recouvrant toutes. Il réalise un effacement par bloc des bulles magnétiques contenues entre ses lignes conductrices formant les branches du U.

Des duplicateurs 58 sont disposés entre l'autre extrémité de chaque boucle mineure et la boucle majeure de lecture 42. On connaît plusieurs types de duplicateurs. Sur la figure 6, on a représenté des duplicateurs comprenant un conducteur d'extension 60 et un conducteur de coupure 62.

Le conducteur d'extension 60 est par exemple constitué d'une suite de segments en forme de U au niveau de chaque boucle mineure. Ces segments sont reliés en série. Sur réception d'une impulsion d'un générateur d'impulsion 66, ils étendent la bulle magnétique située à l'extrémité de chaque boucle mineure entre cette boucle mineure et la boucle majeure de lecture 42.

Le conducteur de coupure 64 est par exemple en forme de U. Il est disposé entre les boucles mineures et la boucle majeure de lecture de manière à croiser chaque segment en U du conducteur d'extension.

Ces duplicateurs permettent le transfert par bloc de bulles des boucles mineures vers la boucle majeure de lecture.

0161160

## REVENDICATIONS

1. Porte d'échange pour mémoire à bulles magnétiques à motifs non implantés comportant une couche de matériau magnétique dans laquelle des bulles peuvent être déplacées par application d'un champ tournant $H_T$ selon un premier et un second chemins de propagation, ledit premier chemin étant défini par un premier ensemble de motifs non implantés alignés suivant un axe, ledit second chemin étant défini par un second ensemble de motifs non implantés alignés suivant un autre axe, lesdits axes étant transversaux, ladite porte d'échange comprenant un conducteur électrique activé pour transférer une bulle du second chemin de propagation vers le premier chemin de propagation, ladite porte d'échange étant caractérisée en ce qu'elle comprend un conducteur électrique d'effacement (30a, 30b) coupant le premier ensemble de motifs suivant un axe perpendiculaire à l'axe d'alignement des motifs dudit premier ensemble.

2. Porte d'échange selon la revendication 1, caractérisée en ce que le conducteur électrique (30a, 30b) est disposé de sorte que la position d'effacement d'une bulle est située sur le sommet d'un motif non-implanté.

3. Porte d'échange selon la revendication 2, caractérisée en ce que ledit motif est l'avant-dernier motif (26a) du premier ensemble de motifs non implantés.

4. Porte d'échange selon l'une quelconque des revendications 2 et 3, caractérisée en ce que le conducteur d'effacement (30a) est en forme de U.

5. Porte d'échange selon l'une quelconque des revendications 2 et 3, caractérisée en ce que le conducteur d'effacement (30b) est linéaire et présente,

B 8247.3 BL

0161160

au niveau de la position d'effacement du premier ensemble une encoche sensiblement parallèle à l'axe d'alignement des motifs dudit premier ensemble.

6. Mémoire à bulles magnétiques à motifs non-implantés comprenant :

- une pluralité de premiers ensembles ($2_1$,.., $2_n$) de motifs non implantés, dits boucles mineures, alignés,

- un deuxième ensemble (4) de motifs non implantés, dit boucle majeure d'écriture, disposé perpendiculairement aux boucles mineures,

- un moyen (44) de génération des bulles sur ladite boucle d'écriture,

- des portes d'échange (48) pour transférer en bloc un élément binaire de la boucle d'écriture dans chaque boucle mineure,

- un troisième ensemble (42) de motifs non impantés, dit boucle majeure de lecture, disposé perpendiculairement aux boucles mineures,

- un détecteur (46) des bulles sur ladite boucle de lecture,

- et des duplicateurs (58) en bloc d'un élément binaire de chaque boucle mineure dans la boucle de lecture, ladite mémoire à bulles étant caractérisée en ce que les portes d'échange sont conformes à l'une quelconque des revendications 1 à 5.

FIG. 1

FIG. 2

FIG. 3

FIG. 5a

FIG. 5b

0161160

FIG. 4

FIG. 6

Office européen
des brevets

**RAPPORT DE RECHERCHE EUROPEENNE**

0161160
Numéro de la demande

EP 85 40 0687

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| A | PATENTS ABSTRACTS OF JAPAN, vol. 6, no. 137 (P-130)(1015), 24 juillet 1982; & JP - A - 57 58 289 (FUJITSU K.K.) 07-04-1982 ----- | 1,3,4, 6 | G 11 C 19/08 |

**DOMAINES TECHNIQUES RECHERCHES (Int. Cl.4)**

G 11 C 19/08

Le présent rapport de recherche a été établi pour toutes les revendications

| Lieu de la recherche | Date d'achèvement de la recherche | Examinateur |
|---|---|---|
| LA HAYE | 11-06-1985 | DEGRAEVE L.W.G. |